# FASCICULE DE BREVET EUROPEEN

(11) **EP 3 437 028 B1**
(45) Date de publication et mention de la délivrance du brevet: **10.11.2021**
(21) Numéro de dépôt: 17717484.4
(22) Date de dépôt: 30.03.2017
(51) Int. Cl.: G06K 19/077

(54) **PROCÉDÉS DE FABRICATION DE CARTES À PUCE ET DE SUPPORTS D'ANTENNE POUR CARTE À PUCE**
VERFAHREN ZUR HERSTELLUNG VON CHIPKARTEN UND VON CHIPKARTENANTENNENTRÄGERN
METHODS OF FABRICATION OF CHIP CARDS AND OF CHIP CARD ANTENNA SUPPORTS

(30) Priorité: 30.03.2016 FR 1652762
(43) Date de publication de la demande: 06.02.2019
(73) Titulaire: Linxens Holding, 78200 Mantes-la-Jolie (FR)
(72) Inventeur: PROYE, Cyril, 78200 MAGNANVILLE (FR); MOUSQUÉ, Valérie, 78520 LIMAY (FR); PAUL, Christophe, 27940 COURCELLES SUR SEINE (FR)
(74) Mandataire: Regi, François-Xavier
(86) Numéro de dépôt international: PCT/FR2017/050735
(87) Numéro de publication internationale: WO 2017/168100

(56) Documents cités:
- EP-A1- 2 221 751
- EP-A1- 2 296 109
- EP-A2- 1 498 843
- FR-A1- 2 863 747
- US-A1- 2015 294 213

## Description

L'invention concerne le domaine des cartes à puces. Les cartes à puce sont bien connues du public, qui en a de multiples usages : cartes de paiement, cartes SIM pour téléphones portables, cartes de transport, cartes d'identité, etc.

Les cartes à puce comportent des moyens de transmission pour transmettre des données d'une puce électronique (circuit intégré) à un dispositif lecteur de carte (lecture) ou de ce dispositif à la carte (écriture). Ces moyens de transmission peuvent être « à contact », « sans contact » ou bien à double-interface lorsqu'ils combinent les deux précédents moyens. L'invention permet de réaliser en particulier des cartes à puce à double interface. Les cartes à puce à double interface sont appelées « dual » si les modes « avec contact » et « sans contact » sont gérés par une seule puce ou « hybrides » si les modes « avec contact » et « sans contact » sont gérés par deux puces physiquement distinctes.

Les cartes à puce à double interface sont généralement constituées d'un support rigide en matière plastique de type PVC, PVC/ABS, PET ou polycarbonate constituant l'essentiel de la carte, dans lequel sont incorporés un module électronique et une antenne. Le module électronique comporte un circuit imprimé généralement flexible muni d'une puce électronique et des plages de contacts électriquement connectées à la puce et affleurant sur le module électronique, en surface du support constitutif de la carte, pour une connexion par contact électrique avec un dispositif lecteur de carte. Les cartes à puce à double interface comportent en outre au moins une antenne pour transmettre des données entre une puce et un système radiofréquence permettant la lecture ou l'écriture des données, sans contact.

Dans l'art antérieur, le module électronique comprenant les contacts et la puce, d'une part, et l'antenne éventuellement intégrée à un support (« inlay » selon la terminologie anglo-saxonne), d'autre part, sont généralement fabriqués séparément, puis l'antenne est connectée au module sur lequel est montée et connectée la puce. Pour des exemples de procédés de connexion d'un module à une antenne on pourra se référer notamment aux documents EP2221751A1, EP2296109A1, US20150294213A1, EP1498843A2 et FR2863747A1. La connexion entre l'antenne et le module est réalisée selon des procédés complexes qui impactent négativement la productivité, les rendements de fabrication et la fiabilité des cartes lors de leur utilisation.

Un but de l'invention est de simplifier ce type de procédés et de fiabiliser la connexion entre l'antenne et le module.

Ce but est au moins en partie atteint grâce à un procédé de fabrication d'une carte à puce selon la revendication 1.

La première face (généralement appelée face contact) comporte au moins une piste conductrice formant un contact pour établir une connexion temporaire avec un dispositif lecteur de cartes. Cette piste est reliée, par l'une de ses faces, électriquement et de manière permanente, à travers un puits de connexion (« via hole » ou through hole » selon la terminologie anglo-saxonne) à une puce électronique et, par l'autre de ses faces, de manière temporaire, à un dispositif de lecture de carte à contacts, lorsque la carte est introduite dans ce dispositif.

Lorsque la deuxième face principale du module est dépourvue de pistes conductrices, au moins l'une des pistes de la première face (mais plus généralement deux de ces pistes) peut (peuvent) être dédiée(s) uniquement à une connexion indirecte avec une antenne (autrement dit cette piste est reliée électriquement d'une part à une puce, et d'autre part, indirectement via l'unité de connexion, à une antenne). L'unité de connexion est placée avec l'antenne, sur ou dans une structure (« inlay » selon la terminologie anglo-saxonne) entre deux couches de matière plastique, avant lamination de celles-ci.

L'utilisation d'une unité de connexion a de nombreux avantages. L'unité de connexion est fabriquée de manière indépendante de l'antenne et du module. Elle peut être fabriquée à l'aide d'un procédé de bobine à bobine. Elle peut être utilisée dans n'importe quel procédé d'encartage d'antenne et de module. Elle permet de concevoir et réaliser facilement des modules à six ou huit plages de contact. Elle est compatible avec de nombreux formats d'antenne et notamment les formats ID1 et 1/2ID1. Elle permet une connexion fiable entre l'antenne et le module, grâce aux plots de connexion qui offrent des portions, éventuellement distinctes, spécifiquement dédiées pour la connexion, respectivement de l'antenne et du module (éventuellement les dimensions de ces portions sont adaptées au type de connexion : thermocompression, ultrasons, soudure, etc.). Elle est compatible aussi bien avec des antennes filaires qu'avec des antennes gravées. Les deux portions de connexion sont situées sur une même face de l'unité de connexion, ce qui permet de réaliser simplement et en continu, par gravure ou par la technologie de « grille de connexion » (technologie « leadframe » selon la technologie anglo-saxonne), les première et deuxième portions. Cette unité de connexion peut être utilisée, notamment en combinaison avec le dépôt de gouttes de soudure sur les deuxièmes portions, pour établir une connexion avec la face arrière d'un contact situé sur la face contact du module simple face ou avec des pistes conductrices sur la face arrière d'un module double face. Cette unité de connexion permet de réaliser des plages de connexion, appelées ci-dessus « deuxièmes portions », de relativement grandes dimensions. Ces plages de connexion sont perforées pour limiter la quantité de matériau de soudure sur celles-ci et par là même réduire l'apport de chaleur nécessaire à la fusion du matériau de soudure.

Le dépôt d'un matériau de soudure ou brasure (par exemple constitué d'un alliage d'étain-bismuth), par exemple sous forme de gouttes, sur les plots de connexion permet, une fois l'unité de connexion intégrée à un support d'antenne de réaliser un produit (« inlay » avec une antenne) qui peut être commercialisé tel quel afin d'être encarté dans des couches de matière plastique et connecté à un module monté dans la carte ultérieurement. Ce produit est prêt à l'emploi et facilite les opérations du fabricant de cartes. En effet, le fabricant de carte n'a plus qu'à assembler des éléments (« inlay » avec une antenne, module et feuilles de matière plastique) fournis éventuellement séparément. L'opération de connexion du module à l'antenne est extrêmement simplifiée par l'utilisation du matériau de soudure déjà en place sur les plots de connexion. En outre, cette opération peut être concomitante de celle consistant à fixer ou coller le module dans sa cavité, soit seulement à l'aide du matériau de soudure lui-même, soit à l'aide d'un matériau de collage tel qu'un adhésif thermo-réactivable, une seule opération de chauffage étant alors nécessaire pour à la fois connecter le module à l'antenne et fixer le module dans sa cavité.

Le procédé selon l'invention peut comporter, en outre, éventuellement l'une ou l'autre des caractéristiques suivantes, considérées séparément ou en combinaison d'une ou plusieurs autres :
- pour faciliter, et éventuellement fiabiliser, la connexion entre l'antenne et le module, le matériau de soudure déposé sur un plot de connexion de l'antenne dépasse, avant son chauffage, de la surface interne d'une cavité réalisée, par exemple par fraisage, dans certaines des couches de matières plastiques ;
- le matériau de soudure est constitué d'un matériau ayant une température de fusion comprise entre 120°C et 230°C, et plus préférentiellement entre 130°C et 150°C ;
- le chauffage du matériau de soudure est réalisé en appliquant sur une zone du module, par exemple à l'aide d'une thermode, une température comprise entre 120°C et 250°C ;
- l'antenne est réalisée sur un support d'antenne, par exemple en enchâssant l'antenne dans un support d'antenne en matière plastique ; ou bien l'antenne est gravée dans une couche de matériau conducteur co-laminée avec un support d'antenne en matériau diélectrique ; ou bien l'antenne est réalisée indépendamment de son support avant d'être reportée sur celui-ci ; le support d'antenne, avec l'antenne, est laminé avec l'unité de connexion et au moins une couche de matière plastique, pour former directement une structure correspondant à la carte à puce ou pour former une structure intermédiaire (« Inlay ») qui est encartée ultérieurement ;
- l'unité de connexion est réalisée sur un film flexible indépendant et éventuellement de nature différente, du support d'antenne ; autrement dit, l'unité de connexion peut être réalisée, indépendamment de l'antenne et de son support, comme une unité sur laquelle sont intégrés au moins deux plots de connexion, chacun de ces plots de connexion étant respectivement dédié à une connexion à une extrémité de l'antenne, avant d'être reportée, en tant qu'entité unique, indépendante et comprenant au moins les deux plots de connexion à l'antenne, sur ou dans le support d'antenne ;
- le support d'antenne comporte un substrat de PVC ;
- la ou les couches de matière plastique, laminées avec le support d'antenne et l'unité de connexion, sont en PVC ; et
- on dépose, dans des ouvertures ménagées dans le substrat du module, à partir de la face arrière d'un module simple face ; un alliage de brasure sur les pistes conductrices dédiées à la connexion avec l'antenne en regard des deuxièmes portions de la couche conductrice de l'unité de connexion ; ainsi, on a du matériau de soudure à la fois sur l'unité de connexion et sur le module.

Le procédé selon l'invention dans son ensemble peut être mis en oeuvre en continu (« reel-to-reel » selon la terminologie anglo-saxonne).

Selon un autre aspect l'invention est une carte à puce selon la revendication 12.

Selon un autre aspect, l'invention est un support d'antenne pour carte à puce selon la revendication 17.

Ainsi, le support d'antenne comporte une unité de connexion avec un matériau de soudure déposé sur la deuxième portion de la couche conductrice avec une épaisseur adaptée pour établir une connexion électrique avec une piste conductrice située sur l'une ou l'autre des faces principales d'un substrat de module de carte à puce, lorsque ce module est positionné dans une cavité de la carte à puce dans laquelle est intégré le support d'antenne, cette deuxième portion comportant une pluralité de perforations.

En outre, le support d'antenne comporte éventuellement l'une ou l'autre des caractéristiques suivantes, considérées séparément ou en combinaison d'une ou plusieurs autres :
- le matériau de soudure est constitué d'un alliage ayant une température de refusion inférieure, égale ou voisine de 200°C ; par exemple il s'agit d'un alliage d'étain ou d'indium ; plus particulièrement, il peut s'agir d'un alliage compris dans la liste composée des alliages d'étain-bismuth, des alliages d'étain, de bismuth et d'argent (SnBiAg), des alliages d'étain, de bismuth et de nickel (SnBiNi), des alliages d'indium et de bismuth (InBi) ; et
- il comporte un substrat de PVC.

Selon encore un autre aspect l'invention est un procédé de fabrication d'un tel support d'antenne dans lequel on lamine l'unité de connexion avec une couche de matière plastique sur laquelle repose l'antenne.

D'autres caractéristiques et avantages de l'invention apparaîtront à la lecture de la description détaillée et des dessins annexés sur lesquels :
- la figure 1 représente schématiquement en perspective une carte à puce selon l'invention ;
- la figure 2 représente, schématiquement et de manière éclatée, un exemple d'empilement de couches constitutives de la carte à puce représentée sur la figure 1 ;
- la figure 3 représente schématiquement, en coupe et de manière agrandie, une portion de l'empilement représenté sur la figure 2 ;
- la figure 4 représente schématiquement, des unités de connexion, à différentes étapes de leur fabrication, entrant dans la constitution de l'empilement représenté sur les figures 2 et 3 ;
- la figure 5 représente schématiquement en perspective une étape du procédé de fabrication de cartes à puce selon l'invention ;
- la figure 6 représente schématiquement en perspective une autre étape du procédé de fabrication de cartes à puce selon l'invention ;
- la figure 7 représente schématiquement, vues de dessus, plusieurs unités de connexion correspondant à un autre mode de réalisation, ces unités de connexion étant encore ensemble sur le film sur lequel elles ont été réalisées ;
- la figure 8 représente schématiquement, vus de dessus, les plots de connexion, selon une caractéristique de l'invention, d'une unité de connexion telle que celles représentées sur la figure 7 ou encore de l'une des unités représentées sur la figure 7 à une étape ultérieure de son procédé de fabrication ;
- la figure 9 représente schématiquement en perspective une unité de connexion correspondant aux plots de connexion de la figure 8, après son individualisation ;
- la figure 10 représente schématiquement un exemple de positionnement d'un module de carte à puce par rapport aux plots de connexion d'une unité de connexion telle que celles représentées sur les figures 7 à 9 ;
- les figures 11 à 13 représentent schématiquement en coupe et de manière éclatée des exemples d'agencement d'une unité de connexion au sein d'un ensemble de couches empilées, constitutives d'une structure intermédiaire de type « inlay » ;
- les figures 14 et 15 représentent en coupe une portion d'un exemple de structure intermédiaire de type « inlay » laminée entre deux couches d'une carte à puce, respectivement avant et après fraisage d'une cavité destinée à recevoir un module de carte à puce ;
- les figures 16A et 16B représentent schématiquement en perspective, respectivement vu de dessous et de dessus, un exemple de module double face à six contacts, de carte à puce (sans la puce, ses fils de connexion et sa résine d'encapsulation) ;
- les figures 17A et 17B représentent schématiquement en perspective, respectivement vu de dessous et de dessus, un exemple de module double face à huit contacts, de carte à puce (sans la puce, ses fils de connexion et sa résine d'encapsulation) ;
- la figure 18 représente schématiquement en perspective, un exemple de cavité réalisée dans une carte à puce et destinée à recevoir un module tel que celui représenté sur les figures 16A à 17B :
- la figure 19 représente schématiquement en perspective, un exemple de carte à puce selon l'invention après mise en place d'un module dans une cavité telle que celle représentée sur la figure 18 ;
- la figure 20 correspond à un agrandissement de la zone du module de la carte représentée sur la figure 19, avec en transparence les plots de connexion de l'unité de connexion de la figure 8 ;
- la figure 21 représente schématiquement en élévation, vu par sa face arrière, une portion d'un exemple de mode de réalisation d'un module ;
- la figure 22 représente schématiquement la relation entre les surfaces respectives des portions des plages de connexion recouvertes du matériau de soudure, d'une part, et des deuxièmes portions des plots de connexion, d'autre part ;
- la figure 23 représente schématiquement en élévation, vu par sa face arrière, une portion d'un autre exemple de mode de réalisation d'un module conforme à l'invention ;
- la figure 24 représente schématiquement la relation entre les surfaces respectives des portions des plages de connexion recouvertes du matériau de soudure, d'une part, et des deuxièmes portions des plots de connexion, d'autre part ; et
- la figure 25 représente schématiquement en coupe une portion d'un plot de connexion en vis-à-vis d'une goutte de matériau de soudure.

Sur les figures, les mêmes références désignent des éléments identiques ou similaires.

Dans ce document les termes « avant », « arrière », « dessus », « dessous », « supérieure », « inférieure », etc. sont purement conventionnels et font, le cas échéant, référence aux orientations telles que représentées sur les figures.

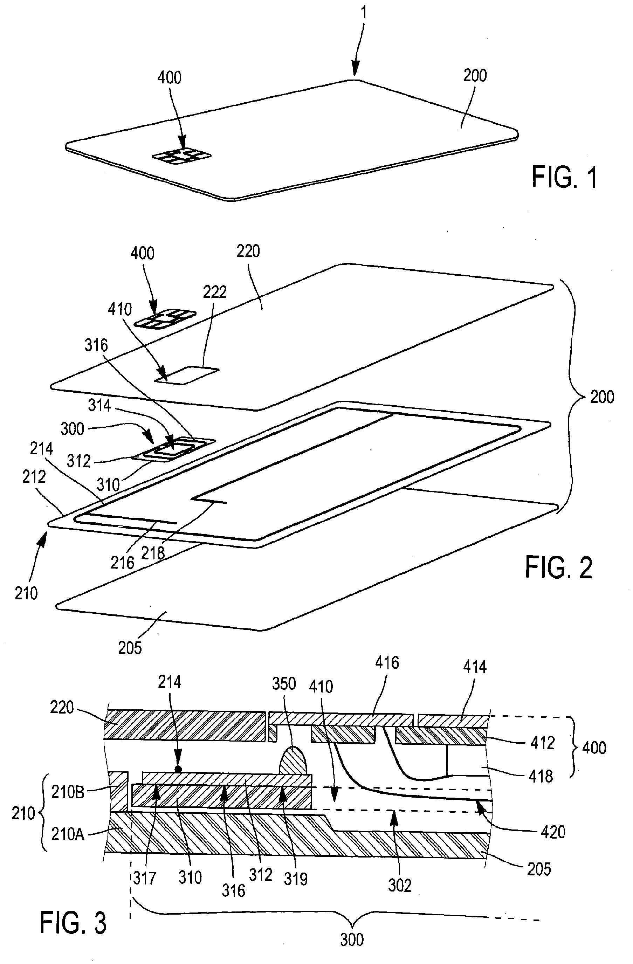

Selon un mode de réalisation d'une carte à puce 1 représentée sur la figure 1, celle-ci comporte un module 400 et un complexe multicouche 200.

Le complexe multicouche 200 est par exemple constitué de différentes couches de matière plastique, telles que (de bas en haut sur la figure 2) :
- une couche inférieure 205,
- un support d'antenne 210, et
- une couche supérieure 220.

La couche inférieure 205 est par exemple une couche de finition (d'impression par exemple) et de protection de la carte 1. Elle est située sous un support d'antenne 210. L'épaisseur de cette couche inférieure 205 en PVC est par exemple de 0,20 mm d'épaisseur avant lamination et de 0,18 mm d'épaisseur après lamination. Cette couche inférieure 205 est d'une épaisseur uniforme et ne comporte pas de découpe destinée à former une cavité pour recevoir un module.

Le support d'antenne 210 comporte un substrat 212 en PVC de 0,43 mm d'épaisseur avant lamination et de 0,40 mm d'épaisseur après lamination. Une antenne filaire 214 par exemple est déposée et fixée au substrat 212 (par exemple enchâssée, par la technique dite en anglais du « wire embedding »). Cette antenne est formée de plusieurs spires enroulées et se termine par deux extrémités 216, 218.

On notera que le support d'antenne 210 peut être composé d'au moins deux sous-couches 210A, 210B (voir figure 3). Dans ce cas, l'antenne 214 est essentiellement insérée par exemple entre la couche du dessous 210A et la couche du dessus 210B et la couche du dessus comporte une découpe pour recevoir une unité de connexion 300, au niveau de laquelle les extrémités 216, 218 de l'antenne 214 sont connectées (dans ce cas, au niveau d'une unité de connexion 300, les extrémités 216, 218 de l'antenne 214 ne sont donc pas insérées entre la couche du dessous 210A et la couche du dessus 210B).

L'unité de connexion 300 comporte un film flexible comprenant un substrat 310 avec une première et une deuxième faces principales (voir aussi figure 3). Une couche conductrice 312 est colaminée sur l'une de ces faces principales. Le substrat 310 est par exemple constitué de matériau de type FR4 ou VEP (verre-epoxy), de 0,075 mm d'épaisseur (et plus généralement inférieure ou égale à 0,1mm). La couche conductrice 312 est par exemple constituée d'un alliage de cuivre en feuillet de 0,03 mm d'épaisseur. Le film flexible est donc par exemple de type stratifié cuivré (« copper clad » selon la terminologie anglo-saxonne).

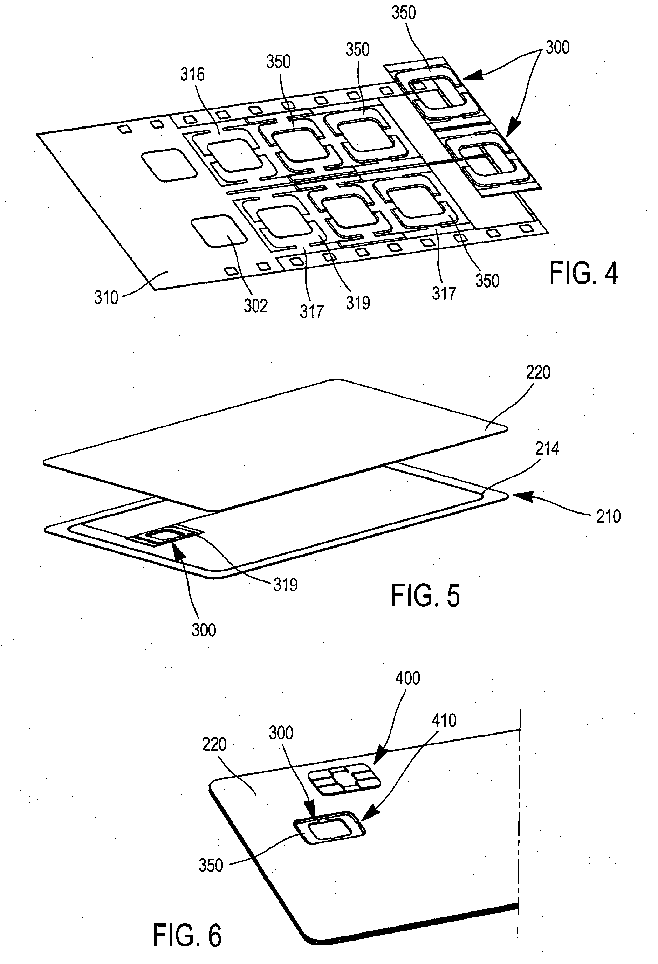

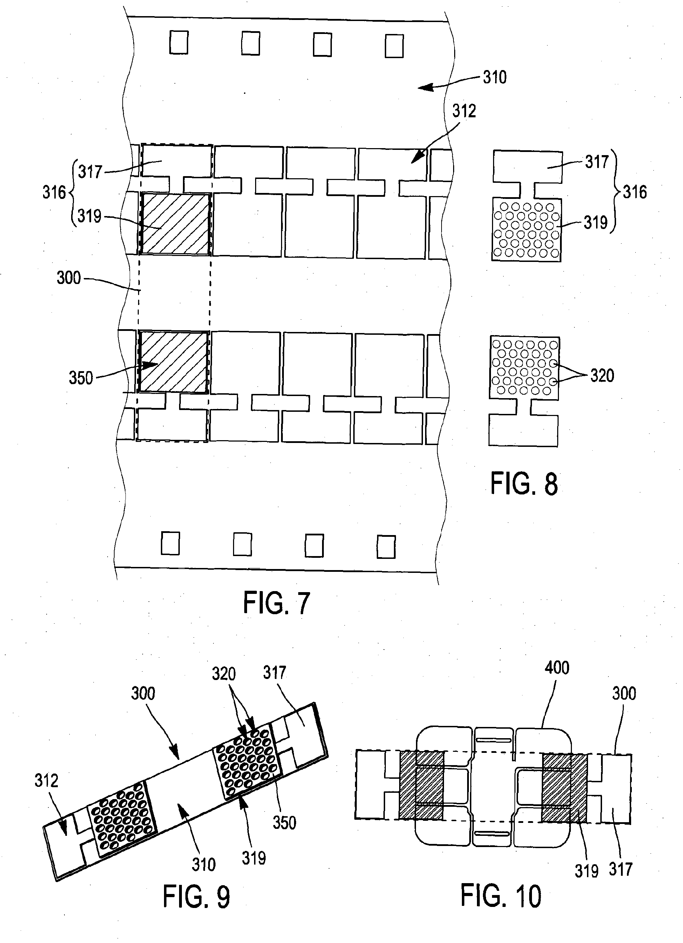

L'unité de connexion 300 a, par exemple, une longueur de 18 mm et une largeur de 4,5 mm. Une ouverture 302 de 8 mm par 4 mm, par exemple, est découpée sensiblement au milieu de l'unité de connexion 300. L'unité de connexion 300 comporte deux plots de connexion 316. Chaque plot de connexion 316 comporte une première 317 et une deuxième 319 portions, électriquement connectées entre elles (voir également figure 4). La première portion 317 a une forme essentiellement rectangulaire. La deuxième portion 319 a une forme de U s'étendant autour des ouvertures 302, avec le fond du U relié (connecté) essentiellement au milieu de la première portion 317 considérée selon sa direction longitudinale. Selon une variante, chaque plot de connexion a une forme en « H » avec chacune des branches parallèles du « H » correspondant respectivement à une première 317 ou une deuxième 319 portion de la zone métallisée, ces première 317 et deuxième 319 portions étant connectées par la branche du milieu. Un exemple de mode de réalisation de cette variante est décrit plus loin en relation avec les figures 7 à 10. Encore d'autres variantes peuvent être envisagées pour la réalisation de l'unité de connexion 300. Par exemple au lieu d'avoir une seule bande conductrice reliant les première 317 et deuxième 319 portions (comme la barre horizontale entre les deux barres verticales d'un « H »), les première 317 et deuxième 319 portions peuvent être reliées par deux, ou trois bandes, voire plus.

Comme représenté sur la figure 4, des unités de connexion 300 sont réalisées (par exemple en continu, de bobine à bobine), à partir d'un film flexible. Les unités de connexion 300 sont donc fabriquées indépendamment du support d'antenne 210 ou du module 400. Ce film flexible est découpé (par exemple par poinçonnage) pour former les ouvertures 302 destinées à recevoir la résine d'encapsulation d'un module 400, comme expliqué plus loin. Des crans d'entrainement sont également découpés. La couche conductrice 312 est ensuite gravée (par exemple selon des techniques de photolithogravure) pour former les plots de connexion 316 (deux plots de connexion 316 par unité de connexion 300), chacun respectivement avec ses première 317 et deuxième 319 portions.

Du matériau de soudure 350 est ensuite déposé sur chacune des premières 317 et deuxièmes 319 portions des plots de connexion 316, sur une épaisseur comprise par exemple entre 0,02 à 0,5mm. Le matériau de soudure 350 est ensuite ôté des premières portions 317. Enfin les unités de connexion 300 sont découpées pour être individualisées. Alternativement, le matériau de soudure 350, est déposé de manière plus sélective, par exemple sous forme de gouttes de soudure, uniquement sur chacune des deuxièmes portions 319 des plots de connexion 316. Le dépôt du matériau de soudure 350 sur les deuxièmes 319 portions (mais comme indiqué plus haut éventuellement aussi sur les premières portions 317) de la couche conductrice des plots de connexion 316 est réalisé par exemple par dispense, par sérigraphie ou encore par la technologie dite à la « vague » (« wave soldering selon la terminologie anglo-saxonne) ; cette technologie permet de déposer du matériau de soudure 350 sur des épaisseurs de l'ordre de 100 ou 200µm, voire moins, et sur des petites surfaces, comme 3x4 mm² par exemple). Chaque goutte de matériau de soudure 350, une fois déposée sur une deuxième portion 319 et avant l'opération de chauffage pour réaliser la soudure entre l'unité de connexion 300 et le module 400, forme un dôme ayant une hauteur comprise entre 0,02 et 0,5 mm. Avantageusement, comme on peut le voir sur la figure 3, chaque goutte de matériau de soudure 350, avant chauffage, dépasse de la surface de la cavité 410 (ou du moins dépasse de la surface supérieure de la sous couche supérieure 210B du support d'antenne, à l'emplacement de la cavité 300). En effet, chaque goutte de matériau de soudure 350, au cours du chauffage, doit venir au contact d'au moins une piste conductrice 416, située sur la face appelée « face avant » ou « face contact » d'un module 400. La mouillabilité du matériau de soudure 350 fondu peut éventuellement suffire pour établir la connexion, même dans les cas où une goutte de matériau de soudure 350 ne ferait qu'affleurer à la surface de la cavité 410 dans laquelle le module 400 vient se loger. Cependant, on peut éviter un contact insuffisant ou défaillant du fait d'une mouillabilité insuffisante en adaptant la hauteur de chaque goutte de matériau de soudure 350 de manière à ce que chaque goutte de matériau de soudure 350 dépasse de la surface du support d'antenne 210. Cette hauteur peut être voisine ou supérieure à l'épaisseur de (ou des) couche(s) supérieure(s) 220 de la carte 200.

Revenant à la description de l'empilement des couches de matière plastique, en relation avec les figures 2 et 3, la couche supérieure 220 de finition et de protection est également par exemple en PVC. Elle fait 0,20 mm d'épaisseur avant lamination et 0,18 mm d'épaisseur après lamination. Cette couche supérieure 220 de finition et de protection comporte une découpe 222 correspondant à une cavité 410. Alternativement, plutôt que de réaliser une découpe 222 dans la ou les différentes couches laminées au-dessus du support d'antenne 210, la cavité 410 est fraisée avant connexion et fixation du module 400 dans la cavité 410.

La couche inférieure 205 et la couche supérieure 220, ainsi que le support d'antenne 210 ne sont pas nécessairement des monocouches. Chacune d'elles peut éventuellement être constituée d'une ou plusieurs couches, toutes laminées ensemble dans la carte 1 finie.

L'épaisseur totale de l'ensemble des couches 205, 210, 220, et donc de la carte 1, est sensiblement de 0,8 mm après lamination.

Un module 400, dit « simple face » est réalisé, par exemple de manière connue, sur un substrat 412 comportant des pistes conductrices 414, 416 sur la face avant (ou « face contact»), et une puce électronique 418, sur l'autre (appelée « face arrière » ou « face bonding ») (voir figure 3). La fixation de la puce électronique 418 sur le substrat 412 est réalisée par au moins une technique connue telle que le fixage de puce (« die-attach » selon la terminologie anglo-saxonne) et sa connexion électrique aux pistes conductrices 414, 416 est réalisée par au moins une technique connue telle que la technologie de la puce retournée (« flip-chip » selon la technologie anglo-saxonne), la soudure de fils (« wirebonding » selon la terminologie anglo-saxonne), etc. La puce 418 et ses éventuelles connexions par fils aux pistes conductrices 414, 416 sont avantageusement protégées par encapsulation dans une résine 420 (« globe top » ou « dam&fill » selon la terminologie anglo-saxonne, correspondant à une encapsulation UV ou thermique). La puce 418 étant placée sur la face arrière du substrat 412 ou dans une découpe réalisée dans celui-ci, l'encapsulation est réalisée à partir de cette face arrière et peut former une surépaisseur par rapport à celle-ci.

Après avoir placé une unité de connexion 300 (éventuellement collée) sur ou dans le support 210, les extrémités 216, 218 de l'antenne 214 sont connectées (par exemple par thermocompression) aux premières portions 317 des plots de connexion 316. On constate donc que les deux plots de connexion 316 d'une unité de connexion 300 sont positionnés ensemble sur ou dans le support 210, lors d'une opération unique, correspondant à la mise en place d'une unité de connexion 300 (alternativement, chaque plot de connexion 316 réalisé sur une portion d'unité de connexion 300 pourrait être individualisé en découpant cette portion ― avec pour résultat l'obtention de deux portions individualisées comportant chacune un plot de connexion 316 - et pourrait être positionné sur ou dans le support 210). Cet ensemble, constitué de l'antenne 214 et de l'unité de connexion 300 sur le support 210, peut être recouvert d'une couche matériau plastique pour former une structure (intermédiaire) qui peut être vendue pour être laminée avec une ou plusieurs autres couches de matériau plastique afin de réaliser une carte à puce 1.

Selon un mode de mise en œuvre du procédé selon l'invention, le support 210 d'antenne est laminé entre des couches de matière plastique (PVC par exemple) 205, 220 en laissant dégagée la cavité 410 dans laquelle un module 400 peut être logé. Chaque cavité 410 a des dimensions telles que les plots de connexion 316 et, surtout ses gouttes de matériau de soudure 350 restent accessibles. Alternativement, la couche supérieure 220 ne comportant pas de découpe 222, le support 210 d'antenne est laminé entre des couches inférieure 205 et supérieure 220 en recouvrant complètement l'unité de connexion 300 (figure 5), puis la cavité 410 dans laquelle un module 400 peut être logé est fraisée (figure 6). Selon ce mode de réalisation, ce fraisage permet non seulement de former la cavité 410 pour qu'elle accommode la puce 418 et la résine d'encapsulation 420, mais aussi de dégager une partie de chaque goutte de matériau de soudure 350, du matériau plastique formant la ou les couches laminées sur le support 210. En effet, le fraisage est réalisé sur au moins une partie du pourtour du matériau de soudure 350, pour dégager le matériau de soudure 350 des couches 350 laminées au-dessus du support 210, et de manière à ce que le matériau de soudure 350 dépasse (avant chauffage) au-dessus de la surface de la cavité 410 (éventuellement la cavité telle que réalisée dans le support 210, sans la couche supérieure). Eventuellement, lors du fraisage de la cavité 410, une partie de chaque goutte de matériau de soudure 350 est ôtée, pour s'assurer que le matériau plastique dans lequel est réalisé le fraisage n'empêchera, ni ne rapprochement des surfaces à souder, ni le matériau formant les gouttes de matériau de soudure 350 en fusion de mouiller les pistes conductrices 416. Eventuellement, le fraisage est réalisé de manière circulaire tout autour de chaque goutte de matériau de soudure 350.

Les premières portions 317 des plots de connexion 316, sur lesquelles ont été connectées les extrémités 216, 218 de l'antenne 214, se trouvent hors de la zone fraisée et restent protégées par la couche supérieure 220. Seules les deuxièmes portions 319 des plots de connexion 316 recouvertes du matériau de soudure 350, ou au moins une portion de la surface ce celles-ci, sont accessibles dans la cavité 410 après fraisage (voir figure 6).

Lorsque le module 400 est en place dans la cavité 410, le matériau de soudure 350, disposé sur chacune des deuxièmes portions 319 des plots de connexion 316, se trouve en vis-à-vis d'ouvertures dans le substrat 412 au niveau desquelles les pistes conductrices 416 sont à nu et accessibles. Les zones du module 400 de trouvant au niveau des gouttes de matériau de soudure 350 sont ensuite chauffées pour faire fondre le matériau de soudure 350 et souder les plots de connexion 316 aux pistes conductrices 416 (Cette opération de chauffage est éventuellement effectuée en même temps que celle consistant à faire chauffer des zones d'adhésif thermo-réactivable, très proches des gouttes de matériau de soudure permettant ainsi de coller chaque module dans sa cavité). On notera que les zones du module 400 de trouvant au niveau des gouttes de matériau de soudure 350 correspondent à des plages conductrices 416 sous lesquelles il n'y a pas de substrat 412, La conduction thermique de la chaleur fournie par une thermode sur les plages conductrices 416 est donc optimisée. En choisissant un matériau de soudure 350 ayant une température de fusion comprise entre 120°C et 230°C, et plus préférentiellement entre 130 et 150°C, on peut réaliser l'opération de chauffage du matériau de soudure 230 en appliquant, avec une thermode par exemple, sur une zone (en vis-à-vis du matériau de soudure 350 par exemple) du module 400, une température comprise entre 120°C et 250°C.

Du fait de l'épaisseur du module 400 et de la hauteur du dôme d'une goutte de matériau de soudure 350, lorsque le matériau de soudure fond, il vient mouiller la piste conductrice 416 correspondante.

La soudure entre les plots de connexion 316 et les pistes conductrices 416 peut couvrir une surface de l'ordre de 2mm² et est telle que l'on obtient une force d'arrachement du module 400 suffisamment élevée, pour répondre aux spécifications de ce type de produit. Le matériau de soudure 350 peut ainsi permettre non seulement d'établir une connexion électrique entre les pistes conductrices 416 et les plots de connexion 316, mais également de fixer le module 400 dans la cavité 410 sans l'aide d'un adhésif.

Une variante du mode de réalisation de l'unité de connexion 300 est illustrée sur la figure 7. Celle-ci diffère de celle décrite plus haut en relation avec les figures 4 à 6, essentiellement par la surface des premières portions 317 et surtout des deuxième portions 319. Comme précédemment, les unités de connexion 300 sont réalisées (par exemple en continu, de bobine à bobine), à partir d'un film flexible, par exemple de type stratifié cuivré. Ce film flexible est découpé (par exemple par poinçonnage) pour former des crans d'entrainement. La couche conductrice 312 est ensuite gravée (par exemple selon des techniques de photolithogravure) pour former les plots de connexion 316 (deux plots de connexion 316 par unité de connexion 300), chacun respectivement avec ses première 317 et deuxième 319 portions. Les deuxièmes portions 319 ont une surface plus grande que dans le cas du mode de réalisation illustré par les figures 4 à 6. Par exemple, elles font environ 4,25mm x 4,5 mm, soit 19,125 mm². Les premières portions 317, quant à elles, font par exemple 2,125 mm x 4,5mm, soir 9,56 mm²,

Les relativement grandes dimensions des deuxièmes portions 319 autorisent des tolérances plus grandes sur le positionnement, en regard de celles-ci, des plages conductrices du module 400. Une tolérance de plus ou moins 1,5 mm sur le positionnement du module 400 dans la carte à puce 1 peut être constaté. Avec des deuxièmes portions 319 d'au moins 4mm de côté, on s'assure d'un recouvrement suffisant des zones à souder en regard l'une de l'autre. On peut constater ce relativement important recouvrement sur l'exemple de positionnement d'un module 400, par rapport à une unité de connexion 300, illustré par la figure 10.

Par ailleurs, la relativement grande surface de matériau métallique recouvrant les plots de connexion 316 (par exemple en cuivre ou l'un de ses alliages, ou en tout autre matériau électriquement conducteur approprié), et notamment au niveau des deuxièmes portions 319, permet une meilleure diffusion de la chaleur lors de l'opération chauffage et de soudure. Le risque de dégrader le ou les matériau(x) constitutif(s) des couches de matière plastique constitutives de la carte à puce 1 finie est ainsi limité, voire nul. En effet, une meilleure diffusion de la chaleur dans la couche électriquement conductrice 312, et en particulier au niveau des deuxièmes portions 319, permet de compenser au moins en partie le fait que lorsque le substrat 310 de l'unité de connexion 300 est en verre-époxy, celui-ci diffuse relativement peu la chaleur. Le risque de dégrader l'aspect visuel des surfaces externes, visibles, de la carte à puce 1 est ainsi également limité, voire annulé.

Le matériau de soudure 350, est déposé de manière sélective uniquement sur chacune des deuxièmes portions 319 des plots de connexion 316. Le dépôt du matériau de soudure 350 sur les deuxièmes 319 portions de la couche conductrice des plots de connexion 316 est réalisé par exemple par dispense, par sérigraphie ou encore par la technologie dite à la « vague ».

Le matériau de soudure 350 occupe sur la surface des deuxièmes portions de connexion 316, une surface d'environ 4,5mmx3mm, sur une épaisseur comprise entre 100µm et 250µm, et par exemple voisine de 150µm. Le matériau de soudure 350 est un alliage ayant une température de fusion voisine de ou égale à 135°C.

Par contre, ces plus grandes surfaces des deuxièmes portions 319 impliquent également de plus grandes surfaces de matériau de soudure 350.

Ainsi, selon une caractéristique de l'invention, illustrée par la figure 8, afin de limiter la quantité de matériau de soudure 350, pour des raisons économiques et pour limiter la quantité de chaleur à fournir pour faire fondre le matériau de soudure 350, des perforations 320 sont réalisées dans la couche conductrice, au niveau des deuxièmes portions 319.

Ces perforations 320 peuvent être réalisées dans le film flexible en même temps que les crans d'entrainement ou à une étape ultérieure. Elles sont réalisées par exemple par poinçonnage. Ces perforations 320 peuvent être réalisées sous diverses formes (rondes, triangulaires, etc.). Par exemple, lorsqu'elles sont de forme ronde, leur diamètre peut être compris entre 0.1mm et 1mm, et avantageusement égal à, ou voisin de, 0.5mm. Les perforations peuvent être disposées en quinconce, en colonnes ou rangées, etc. Elles sont espacées au minimum d'une distance équivalent à leur diamètre, par exemple de 0.1 à 1mm, et avantageusement d'une distance égale à, ou voisine de, 0.5mm.

Alternativement, les perforations peuvent avoir été gravées dans la couche conductrice 312 en même temps que les plots de connexion 316 par exemple. Alternativement encore, dans le cadre de la mise en œuvre d'une technologie par « grille de connexion » (« leadframe »), les perforations peuvent avoir été réalisées dans la couche conductrice 312 en même temps que les plots de connexion 316 par exemple, mais avant report et lamination sur le substrat 310.

Dans tous les cas, il est préférable (mais pas indispensable) de découper les perforations avant de déposer le matériau de soudure 350 sur les deuxièmes portions 319.

Après le dépôt du matériau de soudure 350 sur les deuxièmes portions 319, les unités de connexion 300 sont individualisées. Une unité de connexion 300, individualisée est représentée sur la figure 9.

De nombreuses variantes aux modes de réalisation décrits ci-dessus peuvent être envisagés. Ainsi, divers types d'empilement des couches de matière plastique 205, 210, 220, ainsi que différentes places pour l'unité de connexion 300 dans cet empilement, peuvent être envisagés.

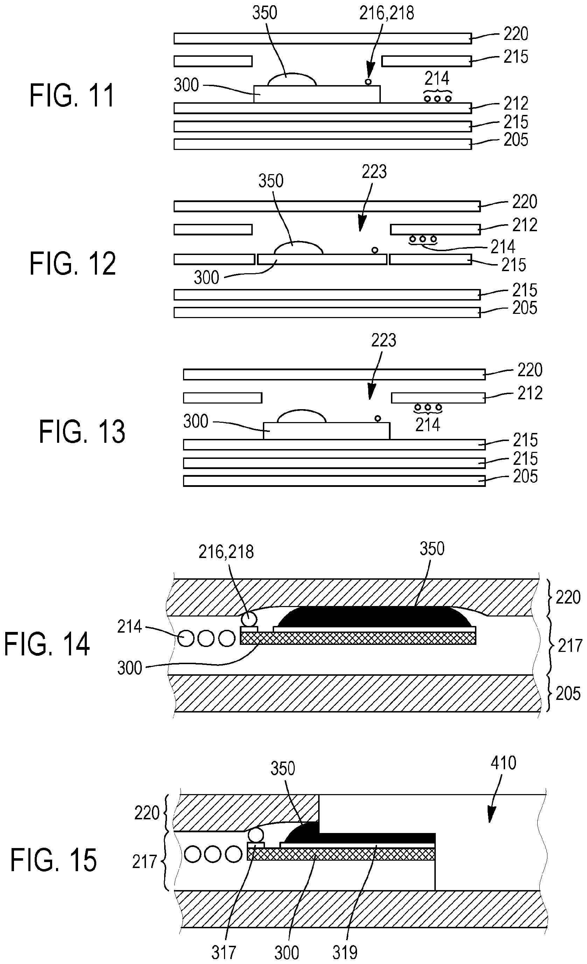

La figure 11 illustre un empilement dans lequel les couches inférieure 205 et supérieure 220 sont des couches de finition (aussi appelées « Overlay » selon la terminologie anglo-saxonne). Des couches intermédiaires 215, par exemple en PVC, sont placées au-dessus et en-dessous du support d'antenne 212. Le support d'antenne 212 comporte une antenne 214, dont une extrémité 216 ou 218 est connectée à une unité de connexion 300 placée au-dessus du support d'antenne 212. Une découpe 222 est ménagée dans une couche intermédiaire 215 afin de loger l'unité de connexion 300 et de former une entretoise entre le support d'antenne 212 et la couche supérieure 220 de finition. Dans cet exemple, l'antenne est placée sur la surface du support d'antenne 212 orientée vers la couche supérieure 220.

La figure 12 illustre un empilement qui diffère de l'empilement de la figure 11, essentiellement par le fait que le support d'antenne 212 est retourné de manière à placer l'antenne sur la surface du support d'antenne 212, orientée vers la couche inférieure 205, par le fait que le support d'antenne 212 comporte une découpe 223 facilitant la mise à nu du matériau de soudure 350 lors de l'opération de fraisage consistant à réaliser une cavité dans la couche supérieure de finition 220, et par le fait que l'unité de connexion 300 repose sur une couche intermédiaire 215 au lieu du support d'antenne 212.

La figure 13 illustre un empilement qui diffère de l'empilement de la figure 11, essentiellement par le fait que le support d'antenne 212 est retourné de manière à placer l'antenne sur la surface du support d'antenne 212, orientée vers la couche inférieure 205, par le fait que le support d'antenne 212 comporte une découpe 223 facilitant la mise à nu du matériau de soudure 350 lors de l'opération de fraisage consistant à réaliser une cavité dans la couche supérieure de finition 220, et par le fait que l'unité de connexion 300 repose sur une couche intermédiaire 215 au lieu du support d'antenne 212.

Dans tous les cas, il est important de positionner l'unité de connexion 300 à une altitude la plus précise possible dans l'empilement (d'où par exemple le fait de placer une deuxième couche intermédiaire 215 sous l'unité de connexion 300 dans l'exemple illustré par la figure 13). La tolérance sur cette altitude dans la carte finie est de plus ou moins 30µm.

L'utilisation du matériau de soudure 350 permet de palier les éventuelles variations sur cette altitude. Comme on peut le voir sur la figure 14, la structure intermédiaire 217 (« inlay ») comprenant les couches intermédiaires, le support d'antenne et l'unité de connexion 300, est laminée en sandwich entre les couches de finition supérieure 220 et inférieure 205. Eventuellement, la présence de la goutte de matériau de soudure 350 sur l'unité de connexion 300 déforme les couches et le sommet du dôme formé par le matériau de soudure 350 se trouve surélevé par rapport au niveau général inférieur de la couche supérieure 220. Lors du fraisage de la cavité 410, la couche supérieure 220 est retirée localement au-dessus du matériau de soudure 350. Mais comme représenté schématiquement sur la figure 15, le fraisage peut être réalisé de manière à retirer un peu plus que l'épaisseur de la couche supérieure de finition 220 tout en conservant suffisamment de matériau de soudure 350 sur les deuxièmes portions 319, pour une connexion ultérieure avec les pistes conductrices d'un module 400 simple ou double face.

Comme déjà expliqué, l'utilisation de l'unité de connexion 300 avec des plages de matériau de soudure 350 sur des deuxièmes portions de relativement grandes dimensions connexion permet de palier les éventuelles variations sur le positionnement de la cavité 410 dans la carte 1. On peut ainsi voir sur la figure 15 que la surface du matériau de soudure 350 sur les deuxièmes portions 319 sous-jacentes permet d'accommoder un certain un décalage de la position de la cavité 350 par rapport à l'unité de connexion 300 tout en conservant suffisamment de matériau de soudure 350 sur les deuxièmes portions 319 pour une connexion ultérieure avec les pistes conductrices d'un module 400 simple ou double face.

De nombreuses autres variantes aux modes de réalisation décrits ci-dessus peuvent être envisagés.

Par exemple, au lieu d'utiliser l'un des modes de réalisation d'une unité de connexion 300 décrits ci-dessus pour réaliser une connexion de l'antenne 214 à un module 400 de type simple face, on peut l'utiliser pour réaliser une connexion de l'antenne 214 à un module 400 de type double face.

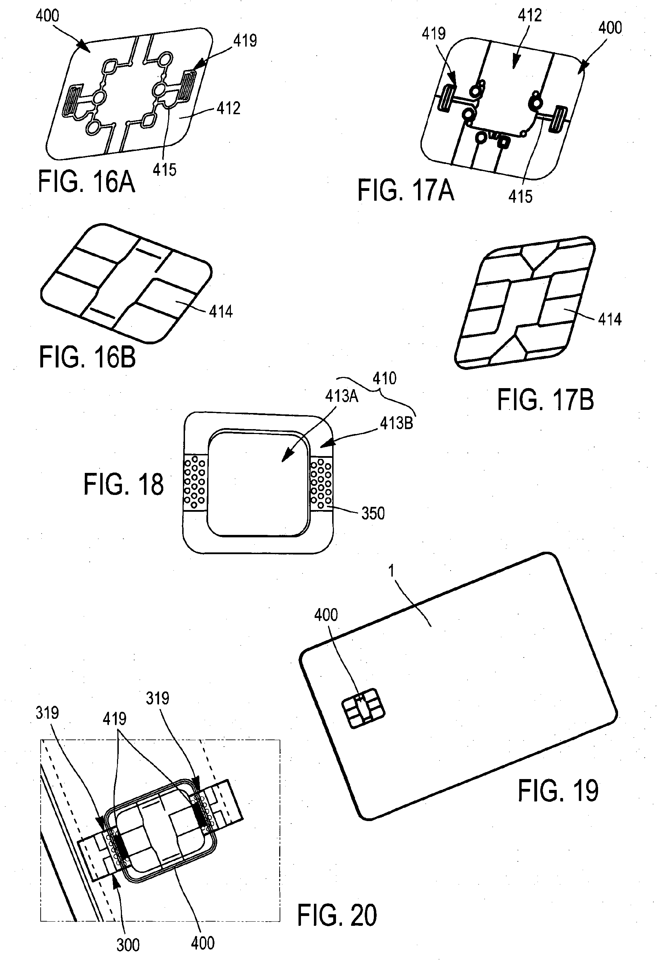

Un exemple de module double face à six contacts (dit « 6 pins ») est représenté sur les figures 16A et 16B. Un exemple de module double face à huit contacts (dit « 8 pins ») est représenté sur les figures 17A et 17B. Ces modules 400, dit « double-face », à six ou huit contacts, sont réalisés par exemple de manière généralement connue (mis à part des détails qui seront précisés ci-dessous comme la forme des pistes conductrices 415 par exemple).

Dans le cas d'un module 400 double face, des pistes conductrices 415, comprenant des plots de connexions 419, sont localisées sur la face arrière du substrat 412.

La figure 18 représente une portion de carte dans laquelle a été fraisée une cavité 410. Cette cavité 410 présente deux niveaux de profondeur. Le niveau le plus profond correspond à la partie centrale 413A et permet d'accommoder une résine d'encapsulation d'une puce et de ses connexions. La partie un peu moins profonde, correspondant à la partie périphérique 413B, forme un siège au niveau duquel le matériau de soudure 350 situé sur les deuxièmes portions 319 a été mis à nu lors du fraisage de la cavité 410. La figure 19 montre un module 400 reporté, placé et fixé dans la cavité 410. Lors du report d'un module 400 tel que ceux représentés sur les figures 16A, 16B, 17A et 17B, les plots de connexion 419 sont placés en vis-à-vis du matériau de soudure 350 affleurant sur la partie périphérique 413B et sur laquelle vient reposer, au niveau de son pourtour, le module 400. Autrement dit, les plots de connexion 419 se trouvent chacun respectivement en vis-à-vis d'une deuxième portion 319 d'un plot de connexion 316 d'une unité de connexion 300. La figure 20 montre en transparence comment sont respectivement positionnés les deuxièmes portions 319 et les plots de connexion 419.

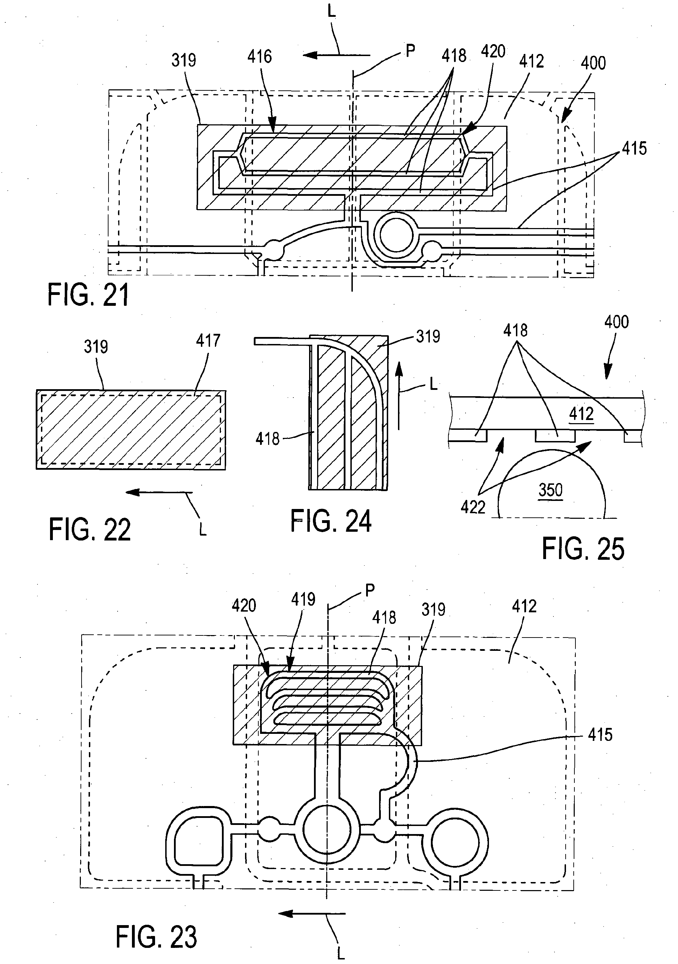

L'utilisation d'unités de connexion 300 telles que celles représentées sur les figures 7 à 10, est particulièrement intéressante en combinaison avec un module 400 double face. En effet, la relativement grande surface des deuxièmes portions 319 et du matériau de soudure 350 qui les recouvre permet d'utiliser des plots de connexion 419 couvrant une zone correspondant également à une relativement grande surface. Cet avantage est illustré par les exemple de modes de réalisation représentés sur les figures 21 à 23.

Une fois la carte 1 finie, le module 400 et l'antenne 214 peuvent éventuellement bouger légèrement l'un par rapport à l'autre au cours de l'utilisation de la carte 1, notamment lorsque la carte 1 subit des torsions. De ce fait la connexion entre l'antenne 214 et le module 400, peut être dégradée, voire rompue. Ce problème est au moins partiellement traité à l'aide des modes de réalisation exemplifiés en relation avec les figures 21 à 23.

Comme représenté sur les figures 21 et 23, les pistes conductrices 415 comportent des plots de connexion 419. Ces plots de connexion 419 sont utilisés pour souder les deuxièmes portions 319 des plages de connexion 316. Ainsi, les extrémités 216, 218 de l'antenne 214, sont elles-mêmes électriquement reliées aux premières portions 317, reliées aux deuxièmes portions 319, qui elles-mêmes sont soudés aux plots de connexion 419, reliés électriquement sur la face arrière du module 400 à la puce par les pistes conductrices 415.

Comme illustré schématiquement par la figure 22, chaque plot de connexion 419 s'étend dans une zone 417 (délimitée par des traits pointillés sur la figure 22) couvrant une surface inférieure à celle des deuxièmes portions 319 (sur les figures 21 à 24 les deuxièmes portions 319 sont représentées sous forme d'un rectangle hachuré, mais elles peuvent avoir d'autres formes et notamment celle en « U » représentée sur les figures 4 à 6). La zone 417 peut être définie comme étant celle qui contient des barres 418 et les portions des pistes conductrices qui relient les barres 418 entre elles. Les barres 418 sont allongées selon une direction L essentiellement perpendiculaire au plus grand côté du module 400, qui est généralement destiné à être parallèle à la longueur de la carte 1.

Dans le mode de réalisation représenté sur la figure 21 (qui correspond par exemple à un module 400 à huit contacts), les barres 418 sont au nombre de trois.

Chaque barre 418 est relativement fine de manière à éventuellement pouvoir se décoller et se désolidariser du substrat 412 du module 400 pour absorber, sans rompre, une contrainte importante. Elle a une largeur par exemple comprise entre 50µm et 300µm. Plus particulièrement, elle peut avoir une largeur voisine de 100µm. Dans ce mode de réalisation, les deux barres 418 les plus éloignées du centre du module 400 ont par exemple une largeur de 100µm et celle la plus proche du centre a une largeur de 150µm.

Les barres 418 ont par exemple une longueur comprise entre 1 et 7mm. Les barres 418 représentées sur les figures 21 et 23 sont essentiellement rectilignes, mais elles pourraient être ondulées, sinusoïdales, etc.

De manière à pouvoir absorber les contraintes de manière la plus uniforme possible, les barres 418 sont essentiellement symétriques par rapport à un plan P perpendiculaire au substrat du module 400 et à la direction longitudinale L, et passant par le milieu du module 400.

Les barres 418 se rejoignent à chacune de leurs extrémités longitudinales et sont connectées aux pistes conductrices 415.

Afin de réduire les contraintes susceptibles de s'accumuler aux extrémités des barres 418, les extrémités de celles-ci se terminent par des portions recourbées 420. Les rayons de courbures des portions recourbées permettent de répartir les contraintes sur une plus grande longueur et une plus grande surface.

Dans le mode de réalisation représenté sur la figure 23 (qui correspond par exemple à un module 400 à six contacts), les barres 418 sont au nombre de quatre et les portions recourbées 420 des extrémités longitudinales des barres sont dirigées vers l'intérieur du module 400. Dans ce mode de réalisation, les trois barres 418 les plus éloignées du centre du module 400 ont par exemple une largeur de 100µm et celle la plus proche du centre a une largeur de 150µm. Leur longueur est préférentiellement comprise entre 1,5 et 3 mm ; par exemple elle est de 2,5 mm. Les portions recourbées 420 ont une forme en arc de cercle avec des rayons de courbure compris entre 35µm (au niveau de la jonction des extrémités des branches 418) et 350 µm (au niveau des extrémités rectilignes des branches 418).

Une variante des plots de connexion 419 décrits en relation avec la figure 23 est illustrée par la figure 24. Selon cette variante, les barres 418 sont au nombre de trois. La longueur des barres 418 est croissante en se rapprochant du centre du module 400 (vers la gauche sur la figure 24). Les extrémités des barres 418 sont reliées et connectées électriquement entre elles par des portions recourbées 430 en arc de cercle. Comme pour le mode réalisation illustré par la figure 23, la surface (en hachuré) de la deuxième portion 319 couverte par le matériau de soudure 350 recouvre la totalité de la zone 417 comprenant les barres 418 et les portions recourbées 420. Lorsque des contraintes s'exercent entre la carte 1 et le module 400, elles ont tendance à s'accumuler au niveau des extrémités des barres 418 et des portions recourbées 420. En enrobant et en scellant les extrémités des barres 418 et les portions recourbées 420, dans le matériau de soudure, ces contraintes se répartissent et se dissipent mieux et de manière plus uniforme sur l'ensemble de la surface couverte par le matériau de soudure 350.

Pour poursuivre la fabrication de la carte à puce 1, le module 400 est mis en place dans la cavité 410, avec le matériau de soudure 350, disposé sur chacune des deuxièmes portions 319 des plages de connexion 316, en vis-à-vis des plots de connexion 419.

Les zones du module 400 de trouvant au niveau des gouttes de matériau de soudure 350 sont ensuite chauffées, par exemple à l'aide d'une thermode, comme pour les modes de réalisation décrits ci-dessus.

Par ailleurs, comme représenté sur la figure 25, les espaces entre les barres 418 forment des gorges 422, délimitées d'une part par les flancs correspondant à l'épaisseur des barres 418, et d'autre part, par le substrat 412 du module 400. Ces gorges 422 permettent de canaliser le matériau de soudure 350 et d'éviter que celui-ci ne se répande largement hors de la zone 417 dans laquelle s'inscrit un plot de connexion 419.

Eventuellement, la soudure entre les plages de connexion 316 et les plots de connexion 416 peut couvrir une surface au moins de l'ordre de 2mm² et est telle que l'on obtient une force d'arrachement du module 400 suffisamment élevée, pour répondre aux spécifications de ce type de produit. Le matériau de soudure 350 permet ainsi éventuellement, non seulement d'établir une connexion électrique entre les plots de connexion 419 et les plages de connexion 316, mais également de fixer le module 400 dans la cavité 410 sans l'aide d'un adhésif.

Dans ce qui précède, il a été décrit une structure de carte à puce 1 dans laquelle une unité de connexion est utilisée pour faire la connexion entre l'antenne 214 et le module 400. Mais, l'invention s'applique également à une structure dans laquelle une antenne et des plages de connexion se trouvent sur un même substrat (par exemple l'antenne et les plages de connexion sont gravées sur un même substrat qui forme alors un support d'antenne 210).

## Revendications

1. Procédé de fabrication d'une carte à puce, comprenant :
- la réalisation d'une antenne (214) pour un couplage électromagnétique avec un dispositif de lecture sans contact de carte, l'antenne (214) comportant au moins deux extrémités (216, 218),
- la lamination d'au moins deux couches de matière plastique entre lesquelles est placée l'antenne (214);
- la mise en place, dans une cavité (410) ménagée dans au moins une couche de matière plastique, d'un module (400) de carte à puce comportant un substrat (412) ayant une première et une deuxième faces principales, avec des pistes conductrices (414, 416), au moins sur la première face principale du substrat (412), cette première face du substrat (412) comportant au moins une piste conductrice (414) dédiée à une connexion électrique temporaire avec un dispositif de lecture de carte à contacts,
**caractérisé par le fait qu'**il comporte en outre
- la fourniture d'une unité de connexion (300) comportant un film flexible comprenant un substrat (310), dit substrat de l'unité de connexion, et une couche conductrice (312), ledit substrat (310) de l'unité de connexion comportant une première et une deuxième faces principales, la couche conductrice (312) étant colaminée sur l'une de ces faces principales, cette couche conductrice (312) comportant au moins un plot de connexion (316) comportant une première (317) et une deuxième (319) portions, électriquement connectées entre elles, l'unité de connexion (300) comportant un matériau de soudure (350) déposé au moins sur la deuxième portion (319), sur une épaisseur comprise entre 0,02 et 0,5mm, avant d'être laminée entre les couches de matière plastique,
- la connexion d'une des extrémités de l'antenne (214) à la première portion (317) de la couche conductrice (312) du plot de connexion (316), et
- la connexion d'une des pistes conductrices (415, 416) du module (400), à la deuxième portion (319) de la couche conductrice (312) du plot de connexion (316), cette deuxième portion (319) comportant une pluralité de perforations (320).

2. Procédé selon la revendication 1, comprenant la connexion d'une des pistes conductrices (415) du module (400) située sur la deuxième face dudit substrat du module (412), à la deuxième portion (319) de la couche conductrice (312) du plot de connexion (316).

3. Procédé selon l'une des revendications précédentes, dans lequel chaque plot de connexion (316) est gravé dans la couche conductrice (312), après que la couche conductrice (312) de l'unité de connexion (300) ait été colaminée sur l'une des faces principales dudit substrat de l'unité de connexion (310).

4. Procédé selon l'une des revendications précédentes, dans lequel on réalise l'antenne sur un support (210), ledit substrat de l'unité de connexion (310), celui-ci étant indépendant du support d'antenne (210).

5. Procédé selon l'une des revendications précédentes, dans lequel une des extrémités de l'antenne (214) et une des pistes conductrices (415, 416) sont connectées au plot de connexion (316) sur une même face de la couche conductrice (312), cette face étant opposée à celle reposant sur ledit substrat de l'unité de connexion (310).

6. Procédé selon l'une des revendications précédentes, dans lequel on chauffe, une fois le module (400) en place dans la cavité (410), le matériau de soudure (350) déposé sur la deuxième portion (319) de la couche conductrice (312) du plot de connexion (316), afin de souder une des pistes conductrices (415, 416) du module (400) dédiée à une connexion d'antenne, avec un plot de connexion (316).

7. Procédé selon l'une des revendications précédentes, dans lequel le dépôt du matériau de soudure (350) sur la deuxième portion (319) de la couche conductrice (312) est réalisé par la technologie dite à la « vague ».

8. Procédé selon l'une des revendications précédentes, dans lequel les pistes conductrices (415, 416) comportent au moins un plot de connexion couvrant chacun une zone (417) ayant une surface inférieure à celle d'une portion de connexion (319) recouverte du matériau de soudure (350).

9. Procédé selon l'une des revendications précédentes, dans lequel les pistes conductrices (415, 416) comportent au moins un plot de connexion comportant au moins deux barres (418) reliées électriquement par leurs extrémités longitudinales, au moins l'une des deux barres ayant des extrémités recourbées vers l'intérieur du module (400).

10. Procédé selon l'une des revendications précédentes, dans lequel on dépose, dans des ouvertures ménagées dans ledit substrat du module (412), un alliage de brasure sur les pistes conductrices (416) dédiées à la connexion avec l'antenne (214) en regard des deuxièmes portions (319) de la couche conductrice (312) de l'unité de connexion (300).

11. Procédé selon l'une des revendications précédentes dans lequel l'unité de connexion (300) est disposée dans une découpe ménagée dans une couche de matière plastique (210B, 215).

12. Carte à puce comportant
- une antenne (214) comportant au moins deux extrémités (216, 218),
- au moins deux couches de matière plastique entre lesquelles est placée l'antenne (214);
- un module (400) de carte à puce comportant un substrat (412), dit substrat du module, ayant une première et une deuxième faces principales, avec des pistes conductrices (414, 415, 416) au moins sur la première face du substrat (412), cette première face du substrat (412) comportant au moins une piste conductrice (414) dédiée à une connexion électrique avec un dispositif de lecture de carte à contacts,
dans laquelle le module (400) est logé dans une cavité (410) ménagée dans au moins l'une des couches de matière plastique,
**caractérisée par le fait qu'**elle comporte en outre une unité de connexion (300) comportant un film flexible comprenant un substrat (310), dit substrat de l'unité de connexion, et une couche conductrice (312), ledit substrat (310) de l'unité de connexion comportant une première et une deuxième faces principales, la couche conductrice (312) étant co-laminée sur l'une de ces faces principales, cette couche conductrice (312) comportant une face tournée vers l'une des faces principales dudit substrat de l'unité de connexion (310) et une face opposée à la face tournée vers l'une des faces principales dudit substrat de l'unité de connexion (310), cette couche conductrice (312) comportant au moins un plot de connexion (316) comportant une première (317) et une deuxième (319) portions situées sur une même face de l'unité de connexion (300), électriquement connectées entre elles, l'unité de connexion (300) comportant en outre un matériau de soudure (350) déposé au moins sur la deuxième portion (319), sur ladite face opposée à la face tournée vers l'une des faces principales du substrat de l'unité de connexion (310), une extrémité de l'antenne étant reliée électriquement à la première portion (317) de la couche conductrice (312), sur ladite face opposée à la face tournée vers l'une des faces principales du substrat de l'unité de connexion (310), et une des pistes conductrices (415, 416) du module (400), étant reliée électriquement à la deuxième portion (319) de la couche conductrice (312) du plot de connexion (316), la deuxième portion (319) comportant une pluralité de perforations (320).

13. Carte à puce selon la revendication 12, dans laquelle une des pistes conductrices (415) du module (400) située sur la deuxième face dudit substrat du module (412) est connectée à la deuxième portion (319) de la couche conductrice (312) du plot de connexion (316).

14. Carte à puce selon l'une des revendications 12 et 13, dans laquelle chaque plot de connexion (316) est gravé dans la couche conductrice (312).

15. Carte à puce selon l'une des revendications 12 à 14, dans laquelle l'antenne est placée sur un support (210) et ledit substrat de l'unité de connexion (310) est indépendant du support d'antenne (210).

16. Carte puce selon l'une des revendications 12 à 15, dans laquelle le module (400) comporte sur la première face dudit substrat du module (412), des contacts (414), et sur la deuxième face dudit substrat du module (412), des plots de connexion (415, 416), couvrant chacun une zone (417) ayant une surface inférieure à celle d'une portion de connexion (319) recouverte du matériau de soudure (350).

17. Support d'antenne pour carte à puce, avec une antenne (214) permettant un couplage électromagnétique avec un dispositif de lecture sans contact de carte, l'antenne (214) comportant au moins deux extrémités (216, 218), **caractérisé par le fait qu'**il comporte en outre une unité de connexion (300) comportant un film flexible comprenant un substrat (310), dit substrat de l'unité de connexion, comportant une première et une deuxième faces principales, la couche conductrice (312) étant co-laminée sur l'une des faces principales dudit substrat de l'unité de connexion (310), cette couche conductrice (312) comprenant une face tournée vers l'une des faces principales dudit substrat de l'unité de connexion (310) et une face opposée à la face tournée vers l'une des faces principales dudit substrat de l'unité de connexion (310), cette couche conductrice (312) comportant
- au moins un plot de connexion (316) comportant une première (317) et une deuxième (319) portions, situées sur une même face de l'unité de connexion (300), et électriquement connectées entre elles, la première portion (317) étant reliée électriquement à l'une des extrémités (216, 218) de l'antenne (214), sur ladite face opposée à la face tournée vers l'une des faces principales dudit substrat de l'unité de connexion (310), et un matériau de soudure (350) étant déposé au moins sur la deuxième portion (319), sur ladite face opposée à la face tournée vers l'une des faces principales dudit substrat de l'unité de connexion (310) et sur une épaisseur comprise entre 0,02 et 0,5mm, cette deuxième portion (319) comportant une pluralité de perforations (320).

18. Support d'antenne selon la revendication 17, dans lequel chaque plot de connexion (316) est gravé dans la couche conductrice (312).

19. Support d'antenne selon la revendication 17 ou 18, dans lequel l'extrémité de l'antenne (214) est connectée au plot de connexion (316) sur une face de la couche conductrice (312) opposée à celle reposant sur ledit substrat de l'unité de connexion (310).

20. Support d'antenne selon l'une des revendications 17 à 19, comprenant plusieurs couches de matière plastique laminées ensemble et dans lequel l'unité de connexion (300) est disposée dans une découpe ménagée dans au moins l'une des couches de matière plastique.

21. Support d'antenne selon l'une des revendications 17 à 20, dans lequel le matériau de soudure (350) est constitué d'un alliage ayant une température de refusion inférieure ou égale à 200°C.

22. Procédé de fabrication d'un support d'antenne selon l'une des revendications 17 à 21, dans lequel on lamine l'unité de connexion (300) avec une couche de matière plastique sur laquelle repose l'antenne (214).

## Patentansprüche

1. Verfahren zur Fertigung einer Chipkarte, umfassend:
- das Herstellen einer Antenne (214) für eine elektromagnetische Kopplung mit einer kontaktlosen Kartenlesevorrichtung, wobei die Antenne (214) mindestens zwei Enden (216, 218) aufweist,
- das Laminieren mindestens zweier Kunststoffschichten zwischen denen die Antenne (214) platziert ist;
- das Einbringen, in einen Hohlraum (410), der in mindestens einer Kunststoffschicht ausgebildet ist, eines Chipkartenmoduls (400), das ein Substrat (412) mit einer ersten und einer zweiten Hauptseite mit Leiterbahnen (414, 416) wenigstens auf der ersten Hauptseite des Substrats (412) aufweist, wobei diese erste Seite des Substrats (412) mindestens eine Leiterbahn (414) aufweist, die für eine temporäre elektrische Verbindung mit einer Kartenlesevorrichtung mit Kontakten vorgesehen ist,
**dadurch gekennzeichnet, dass** es ferner Folgendes aufweist
- das Bereitstellen einer Verbindungseinheit (300), die einen flexiblen Film aufweist, der ein Substrat (310) der Verbindungseinheit und eine leitende Schicht (312) umfasst, wobei das Substrat (310) der Verbindungseinheit eine erste und eine zweite Hauptseite aufweist, wobei die leitende Schicht (312) auf eine dieser Hauptseiten colaminiert ist, wobei diese leitende Schicht (312) mindestens ein Verbindungsfeld (316) aufweist, das einen ersten (317) und einen zweiten (319) Abschnitt aufweist, die miteinander elektrisch verbunden sind, wobei die Verbindungseinheit (300) ein Lötmaterial (350) aufweist, das wenigstens auf dem zweiten Abschnitt (319) über eine Dicke zwischen 0,02 und 0,5 mm aufgebracht wird, bevor sie zwischen den Kunststoffschichten laminiert wird,
- das Verbinden eines der Enden der Antenne (214) mit dem ersten Abschnitt (317) der leitenden Schicht (312) des Verbindungsfelds (316), und
- das Verbinden einer der Leiterbahnen (415, 416) des Moduls (400) mit dem zweiten Abschnitt (319) der leitenden Schicht (312) des Verbindungsfelds (316), wobei dieser zweite Abschnitt (319) eine Mehrzahl von Perforationen (320) aufweist.

2. Verfahren nach Anspruch 1, umfassend das Verbinden einer der Leiterbahnen (415) des Moduls (400), die sich auf der zweiten Seite des Substrats des Moduls (412) befindet, mit dem zweiten Abschnitt (319) der leitenden Schicht (312) des Verbindungsfelds (316).

3. Verfahren nach einem der vorhergehenden Ansprüche, wobei jedes Verbindungsfeld (316) in die leitende Schicht (312) eingraviert wird, nachdem die leitende Schicht (312) der Verbindungseinheit (300) auf eine der Hauptseiten des Substrats der Verbindungseinheit (310) colaminiert wurde.

4. Verfahren nach einem der vorhergehenden Ansprüche, wobei die Antenne auf einem Träger (210) hergestellt wird, dem Substrat der Verbindungseinheit (310), wobei dieses vom Antennenträger (210) unabhängig ist.

5. Verfahren nach einem der vorhergehenden Ansprüche, wobei eins der Enden der Antenne (214) und eine der Leiterbahnen (415, 416) auf einer selben Seite der leitenden Schicht (312) mit dem Verbindungsfeld (316) verbunden sind, wobei diese Seite jener gegenüberliegt, die auf dem Substrat der Verbindungseinheit (310) aufliegt.

6. Verfahren nach einem der vorhergehenden Ansprüche, wobei das Lötmaterial (350), das auf den zweiten Abschnitt (319) der leitenden Schicht (312) des Verbindungsfelds (316) aufgebracht ist, erhitzt wird, sobald das Modul (400) im Hohlraum (410) sitzt, um eine der Leiterbahnen (415, 416) des Moduls (400), die für eine Antennenverbindung vorgesehen ist, mit einem Verbindungsfeld (316) zu verlöten.

7. Verfahren nach einem der vorhergehenden Ansprüche, wobei das Aufbringen des Lötmaterials (350) auf den zweiten Abschnitt (319) der leitenden Schicht (312) durch die "Wellen"-Technik erreicht wird.

8. Verfahren nach einem der vorhergehenden Ansprüche, wobei die Leiterbahnen (415, 416) mindestens ein Verbindungsfeld aufweisen, die jeweils einen Bereich (417) mit einer Fläche kleiner als jene eines Verbindungsabschnitts (319) abdecken, der vom Lötmaterial (350) bedeckt ist.

9. Verfahren nach einem der vorhergehenden Ansprüche, wobei die Leiterbahnen (415, 416) mindestens ein Verbindungsfeld aufweisen, das mindestens zwei Schienen (418) aufweist, die über ihre Längsenden elektrisch verbunden sind, wobei mindestens eine der zwei Schienen Enden aufweist, die zum Inneren des Moduls (400) hin gekrümmt sind.

10. Verfahren nach einem der vorhergehenden Ansprüche, wobei in Öffnungen, die im Substrat des Moduls (412) ausgebildet sind, eine Lötlegierung auf die Leiterbahnen (416), die zur Verbindung mit der Antenne (214) vorgesehen sind, gegenüber den zweiten Abschnitten (319) der leitenden Schicht (312) der Verbindungseinheit (300) aufgebracht wird.

11. Verfahren nach einem der vorhergehenden Ansprüche, wobei die Verbindungseinheit (300) in einem Ausschnitt angeordnet wird, der in der Kunststoffschicht (210B, 215) ausgebildet ist.

12. Chipkarte aufweisend
- eine Antenne (214), die mindestens zwei Enden (216, 218) aufweist,
- mindestens zwei Kunststoffschichten, zwischen denen die Antenne (214) platziert ist;
- ein Chipkartenmodul (400), das ein Substrat (412) des Moduls mit einer ersten und einer zweiten Hauptseite mit Leiterbahnen (414, 415, 416) wenigstens auf der ersten Hauptseite des Substrats (412) aufweist, wobei diese erste Seite des Substrats (412) mindestens eine Leiterbahn (414) aufweist, die für eine elektrische Verbindung mit einer Kartenlesevorrichtung mit Kontakten vorgesehen ist,
wobei das Modul (400) in einem Hohlraum (410) untergebracht ist, der in wenigstens einer der Kunststoffschichten ausgebildet ist,
**dadurch gekennzeichnet, dass** sie ferner eine Verbindungseinheit (300) aufweist, die einen flexiblen Film aufweist, der ein Substrat (310) der Verbindungseinheit und eine leitende Schicht (312) umfasst, wobei das Substrat (310) der Verbindungseinheit eine erste und eine zweite Hauptseite aufweist, wobei die leitende Schicht (312) auf eine dieser Hauptseiten colaminiert ist, wobei diese leitende Schicht (312) eine Seite, die zu einer der Hauptseiten des Substrats der Verbindungseinheit (310) gewandt ist, und eine Seite gegenüber der Seite, die zu einer der Hauptseiten des Substrats der Verbindungseinheit (310) gewandt ist, aufweist, wobei diese leitende Schicht (312) mindestens ein Verbindungsfeld (316) aufweist, das einen ersten (317) und einen zweiten (319) Abschnitt aufweist, die sich auf einer selben Seite der Verbindungseinheit (300) befinden, die miteinander elektrisch verbunden sind, wobei die Verbindungseinheit (300) ferner ein Lötmaterial (350) aufweist, das wenigstens auf dem zweiten Abschnitt (319) aufgebracht ist, auf der Seite gegenüber der Seite, die zu einer der Hauptseiten des Substrats der Verbindungseinheit (310) gewandt ist, wobei ein Ende der Antenne mit dem ersten Abschnitt (317) der leitenden Schicht (312) elektrisch verbunden ist, auf der Seite gegenüber der Seite, die zu einer der Hauptseiten des Substrats der Verbindungseinheit (310) gewandt ist, und wobei eine der Leiterbahnen (415, 416) des Moduls (400) mit dem zweiten Abschnitt (319) der leitenden Schicht (312) des Verbindungsfelds (316) elektrisch verbunden ist, wobei der zweite Abschnitt (319) eine Mehrzahl von Perforationen (320) aufweist.

13. Chipkartenmodul nach Anspruch 12, wobei eine der Leiterbahnen (415) des Moduls (400), die sich auf der zweiten Seite des Substrats des Moduls (412) befindet, mit dem zweiten Abschnitt (319) der leitenden Schicht (312) des Verbindungsfelds (316) verbunden ist.

14. Chipkarte nach einem der Ansprüche 12 und 13, wobei jedes Verbindungsfeld (316) in die leitende Schicht (312) eingraviert ist.

15. Chipkarte nach einem der Ansprüche 12 bis 14, wobei die Antenne auf einem Träger (210) platziert ist und das Substrat der Verbindungseinheit (310) vom Antennenträger (210) unabhängig ist.

16. Chipkarte nach einem der Ansprüche 12 bis 15, wobei das Modul (400) auf der ersten Seite des Substrats des Moduls (412) Kontakte (414) und auf der zweiten Seite des Substrats des Moduls (412) Verbindungsfelder (415, 416) aufweist, die jeweils einen Bereich (417) mit einer Fläche kleiner als jene eines Verbindungsabschnitts (319) abdecken, der vom Lötmaterial (350) bedeckt ist.

17. Antennenträger für Chipkarte, mit einer Antenne (214), die eine elektromagnetische Kopplung mit einer kontaktlosen Kartenlesevorrichtung gestattet, wobei die Antenne (214) mindestens zwei Enden (216, 218) aufweist, **dadurch gekennzeichnet, dass** er ferner eine Verbindungseinheit (300) aufweist, die einen flexiblen Film aufweist, der ein Substrat (310) der Verbindungseinheit umfasst, das eine erste und eine zweite Hauptseite aufweist, wobei die leitende Schicht (312) auf eine der Hauptseiten des Substrats der Verbindungseinheit (310) colaminiert ist, wobei diese leitende Schicht (312) eine Seite, die zu einer der Hauptseiten des Substrats der Verbindungseinheit (310) gewandt ist, und eine Seite gegenüber der Seite, die zu einer der Hauptseiten des Substrats der Verbindungseinheit (310) gewandt ist, aufweist, wobei diese leitende Schicht (312) Folgendes aufweist:
- mindestens ein Verbindungsfeld (316), das einen ersten (317) und einen zweiten (319) Abschnitt aufweist, die sich auf einer selben Seite der Verbindungseinheit (300) befinden und miteinander elektrisch verbunden sind, wobei der erste Abschnitt (317) mit einem der Enden (216, 218) der Antenne (214) elektrisch verbunden ist, auf der Seite gegenüber der Seite, die zu einer der Hauptseiten des Substrats der Verbindungseinheit (310) gewandt ist, und ein Lötmaterial (350) wenigstens auf dem zweiten Abschnitt (319) aufgebracht ist, auf der Seite gegenüber der Seite, die zu einer der Hauptseiten des Substrats der Verbindungseinheit (310) gewandt ist, und über eine Dicke zwischen 0,02 und 0,5 mm, wobei dieser zweite Abschnitt (319) eine Mehrzahl von Perforationen (320) aufweist.

18. Antennenträger nach Anspruch 17, wobei jedes Verbindungsfeld (316) in die leitende Schicht (312) eingraviert ist.

19. Antennenträger nach Anspruch 17 oder 18, wobei das Ende der Antenne (214) mit dem Verbindungsfeld (316) auf einer Seite der leitenden Schicht (312) gegenüber jener, die auf dem Substrat der Verbindungseinheit (310) aufliegt, verbunden ist.

20. Antennenträger nach einem der Ansprüche 17 bis 19, umfassend mehrere Kunststoffschichten, die zusammenlaminiert sind, und wobei die Verbindungseinheit (300) in einem Ausschnitt angeordnet ist, der in mindestens einer der Kunststoffschichten ausgebildet ist.

21. Antennenträger nach einem der Ansprüche 17 bis 20, wobei das Lötmaterial (350) von einer Legierung mit einer Wiederaufschmelztemperatur kleiner als oder gleich 200 °C gebildet ist.

22. Verfahren zur Fertigung eines Antennenträgers nach einem der Ansprüche 17 bis 21, wobei die Verbindungseinheit (300) mit einer Kunststoffschicht laminiert wird, auf der die Antenne (214) aufliegt.

## Claims

1. Method for manufacturing a chip card, comprising:
- producing an antenna (214) for electromagnetic coupling with a contactless card-reader device, the antenna (214) having at least two ends (216, 218),
- laminating at least two layers of plastic, between which layers the antenna (214) is positioned,
- introducing, into a cavity (410) formed in at least one layer of plastic, a chip card module (400) including a substrate (412) having a first main face and a second main face, with conductive tracks (414, 416) at least on the first main face of the substrate (412), this first face of the substrate (412) having at least one conductive track (414) set apart for a temporary electrical connection with a contact card-reader device, **characterized in that** it furthermore includes
- providing a connection unit (300) having a flexible film comprising a substrate (310), called substrate of the connection unit, and a conductive layer (312), said substrate (310) of the connection unit having a first main face and a second main face, the conductive layer (312) being colaminated on one of these main faces, this conductive layer (312) including at least one connection pad (316) having a first portion (317) and a second portion (319) that are connected electrically to one another, the connection unit (300) including a solder material (350) deposited at least on the second portion (319), over a thickness of between 0.02 and 0.5 mm, before being laminated between the layers of plastic,
- connecting one of the ends of the antenna (214) to the first portion (317) of the conductive layer (312) of the connection pad (316),
and
- connecting one of the conductive tracks (415, 416) of the module (400) to the second portion (319) of the conductive layer (312) of the connection pad (316), this second portion (319) having a plurality of perforations (320).

2. Method according to Claim 1, comprising connecting one of the conductive tracks (415) of the module (400), which track is situated on the second face of said substrate (412) of the module, to the second portion (319) of the conductive layer (312) of the connection pad (316).

3. Method according to either of the preceding claims, wherein each connection pad (316) is etched into the conductive layer (312), after the conductive layer (312) of the connection unit (300) has been colaminated on one of the main faces of said substrate (310) of the connection unit.

4. Method according to one of the preceding claims, wherein the antenna is produced on a carrier (210), said substrate (310) of the connection unit, this substrate (310) being independent of the antenna carrier (210).

5. Method according to one of the preceding claims, wherein one of the ends of the antenna (214) and one of the conductive tracks (415, 416) are connected to the connection pad (316) on one and the same face of the conductive layer (312), this face being opposite the one resting on said substrate (310) of the connection unit.

6. Method according to one of the preceding claims, wherein, once the module (400) is in position in the cavity (410), the solder material (350) deposited on the second portion (319) of the conductive layer (312) of the connection pad (316) is heated so as to solder one of the conductive tracks (415, 416) of the module (400), which track is set apart for an antenna connection, to a connection pad (316).

7. Method according to one of the preceding claims, wherein the solder material (350) is deposited on the second portion (319) of the conductive layer (312) by what is termed "wave soldering" technology.

8. Method according to one of the preceding claims, wherein the conductive tracks (415, 416) include at least one connection pad each covering a zone (417) having an area smaller than that of a connection portion (319) covered with the solder material (350).

9. Method according to one of the preceding claims, wherein the conductive tracks (415, 416) include at least one connection pad having at least two bars (418) linked electrically by their longitudinal ends, at least one of the two bars having ends that are curved towards the inside of the module (400).

10. Method according to one of the preceding claims, wherein, in apertures formed in said substrate (412) of the module, a solder alloy is deposited onto the conductive tracks (416) set apart for the connection with the antenna (214) facing the second portions (319) of the conductive layer (312) of the connection unit (300).

11. Method according to one of the preceding claims, wherein the connection unit (300) is arranged in a cutout formed in a layer of plastic (210B, 215).

12. Chip card including
- an antenna (214) having at least two ends (216, 218),
- at least two layers of plastic, between which layers the antenna (214) is positioned,
- a chip card module (400) including a substrate (412), called substrate of the module, having a first main face and a second main face, with conductive tracks (414, 415, 416) at least on the first face of the substrate (412), this first face of the substrate (412) having at least one conductive track (414) set apart for an electrical connection with a contact card-reader device,
wherein the module (400) is housed in a cavity (410) formed in at least one of the layers of plastic,
**characterized in that** it furthermore includes a connection unit (300) having a flexible film comprising a substrate (310), called substrate of the connection unit, and a conductive layer (312), said substrate (310) of the connection unit having a first main face and a second main face, the conductive layer (312) being colaminated on one of these main faces, this conductive layer (312) including a face facing one of the main faces of said substrate (310) of the connection unit and a face opposite the face facing one of the main faces of said substrate (310) of the connection unit, this conductive layer (312) including at least one connection pad (316) having a first portion (317) and a second portion (319) that are situated on one and the same face of the connection unit (300) and connected electrically to one another, the connection unit (300) furthermore including a solder material (350) deposited at least on the second portion (319), on said face opposite the face facing one of the main faces of the substrate (310) of the connection unit, one end of the antenna being linked electrically to the first portion (317) of the conductive layer (312), on said face opposite the face facing one of the main faces of the substrate (310) of the connection unit, and one of the conductive tracks (415, 416) of the module (400) being linked electrically to the second portion (319) of the conductive layer (312) of the connection pad (316), the second portion (319) having a plurality of perforations (320).

13. Chip card according to Claim 12, wherein one of the conductive tracks (415) of the module (400), which track is situated on the second face of said substrate (412) of the module, is connected to the second portion (319) of the conductive layer (312) of the connection pad (316).

14. Chip card according to either of Claims 12 and 13, wherein each connection pad (316) is etched into the conductive layer (312).

15. Chip card according to one of Claims 12 to 14, wherein the antenna is positioned on a carrier (210) and said substrate (310) of the connection unit is independent of the antenna carrier (210).

16. Chip card according to one of Claims 12 to 15, wherein the module (400) includes contacts (414) on the first face of said substrate (412) of the module, and includes, on the second face of said substrate (412) of the module, connection pads (415, 416) each covering a zone (417) having an area smaller than that of a connection portion (319) covered with the solder material (350).

17. Antenna carrier for a chip card, with an antenna (214) enabling electromagnetic coupling with a contactless card-reader device, the antenna (214) having at least two ends (216, 218),
**characterized in that** it furthermore includes a connection unit (300) having a flexible film comprising a substrate (310), called substrate of the connection unit, having a first main face and a second main face, the conductive layer (312) being colaminated on one of the main faces of said substrate (310) of the connection unit, this conductive layer (312) including a face facing one of the main faces of said substrate (310) of the connection unit and a face opposite the face facing one of the main faces of said substrate (310) of the connection unit, this conductive layer (312) including
- at least one connection pad (316) having a first portion (317) and a second portion (319) that are situated on one and the same face of the connection unit (300) and connected electrically to one another, the first portion (317) being linked electrically to one of the ends (216, 218) of the antenna (214), on said face opposite the face facing one of the main faces of said substrate (310) of the connection unit, and a solder material (350) being deposited at least on the second portion (319), on said face opposite the face facing one of the main faces of said substrate (310) of the connection unit and over a thickness of between 0.02 and 0.5 mm, this second portion (319) having a plurality of perforations (320).

18. Antenna carrier according to Claim 17, wherein each connection pad (316) is etched into the conductive layer (312).

19. Antenna carrier according to Claim 17 or 18, wherein the end of the antenna (214) is connected to the connection pad (316) on a face of the conductive layer (312) opposite the one resting on said substrate of the connection unit (310).

20. Antenna carrier according to one of Claims 17 to 19, comprising a plurality of layers of plastic laminated together, and wherein the connection unit (300) is arranged in a cutout formed in at least one of the layers of plastic.

21. Antenna carrier according to one of Claims 17 to 20, wherein the solder material (350) is formed of an alloy having a remelting point of less than or equal to 200°C.

22. Method for manufacturing an antenna carrier according to one of Claims 17 to 21, wherein the connection unit (300) is laminated with a layer of plastic on which the antenna (214) rests.
